# EUROPEAN PATENT APPLICATION

(11) **EP 4 593 541 A1**
(43) Date of publication of application: **30.07.2025**
(21) Application number: 25153767.6
(22) Date of filing: 24.01.2025
(51) Int. Cl.: H05K 7/20

(54) **CONTAINERISED DATA CENTRES**

(30) Priority: 24.01.2024 CN 202420179198 U
(71) Applicant: Bitmain Technologies Inc., Beijing 100094 (CN)
(72) Inventor: LI, Fengjie, Beijing, 100094 (CN); HU, Hangkong, Beijing, 100094 (CN); HUANG, Shaoming, Beijing, 100094 (CN); GE, Yongbo, Beijing, 100094 (CN); ZHANG, Xiaoxiong, Beijing, 100094 (CN); GENG, Tuo, Beijing, 100094 (CN); LI, Tianhao, Beijing, 100094 (CN); ZHU, Hongshan, Beijing, 100094 (CN); CUI, Wenkai, Beijing, 100094 (CN); HUA, Shuangquan, Beijing, 100094 (CN); XIE, Jinquan, Beijing, 100094 (CN)
(74) Representative: Elzaburu S.L.P.

(57) **Abstract**

The present application provides a containerized data center, which relates to the field of the data center technology. The containerized data center includes: a data container, including a container body, and a side wall of the container body is provided with a vent; a heat dissipation module, installed on an outer wall of the container body, and provided corresponding to the vent; where the heat dissipation module includes a housing, a fan and a heat exchanger; the housing is sealed and connected to the outer wall of the container body and is communicated with the vent; both the fan and the heat exchanger are provided in the housing, where the fan guides the air in the container body to the heat exchanger, and the heat exchanger is connected with a liquid cooling source. The containerized data center provided has a simple structure, easy assembly, high heat dissipation efficiency, good heat dissipation effect, low energy consumption and pollution-free nature.

## Description

### TECHNICAL FIELD

The present disclosure relates to the field of data center technology, and in particular, to a containerized data center.

### BACKGROUND

Due to shortcomings of traditional data centers, such as long construction periods, high construction costs and large space occupation, containerized data centers have emerged. Containerized data centers are designed flexibly can be rapidly deployed, and have now been widely adopted.

When the containerized data centers are used in special environment areas such as high salt and alkali, and high humidity, equipment inside the containers is vulnerable to be affected by the external environment, which affects its lifetime. At this time, sealed containers are usually selected to prevent external air from entering, to protect the equipment inside the container.

However, sealed containers will cause the heat generated by internal equipment cannot be effectively dissipated, resulting in excessively high operating temperature of equipment, which will affect operating performance of the equipment, and even cause the equipment damage.

### SUMMARY

The present application provides a containerized data center, which has a simple structure, easy assembly, high heat dissipation efficiency, good heat dissipation effect, low energy consumption and pollution-free nature.

The present application provides a containerized data center, including:
a data container, including a container body, and a side wall of the container body is provided with a vent;
a heat dissipation module, installed on an outer wall of the container body, and provided corresponding to the vent;
where the heat dissipation module includes a housing, a fan and a heat exchanger; the housing is sealed and connected to the outer wall of the container body, and is communicated with the vent; both the fan and the heat exchanger are provided in the housing, where the fan guides air in the container body to the heat exchanger, and the heat exchanger is connected with a liquid cooling source.

In a possible implementation, the fan is located above the heat exchanger.

In a possible implementation, the vent includes an air outlet portion and an air inlet portion;
the air outlet portion is provided above the air inlet portion, the fan is provided corresponding to the air outlet portion, and the heat exchanger is provided corresponding to the air inlet portion.

In a possible implementation, there is a gap between the heat exchanger and a rear wall portion of the housing, and the heat exchanger and the housing are enclosed together to form an air inlet chamber;
where the rear wall portion is a side wall of the housing away from the container body.

In a possible implementation, a first flow guide portion is provided in the housing, the first flow guide portion is located between the fan and the heat exchanger;
where an upper end of the first flow guide portion is connected to a front wall portion of the housing, and a lower end of the first flow guide portion is inclined towards the air inlet chamber; the front wall portion is a side wall of the housing facing the container body.

In a possible implementation, the rear wall portion of the housing has a second flow guide portion, the second flow guide portion is located at a bottom end of the rear wall portion;
and, the second flow guide is inclined towards the housing from an upper end of the second flow guide portion to a lower end of the second flow guide portion.

In a possible implementation, a sealing layer is provided between the housing and the outer wall of the housing.

In a possible implementation, the heat dissipation module is provided corresponding to a high heat generation area of the data container.

In a possible implementation, the heat exchanger is provided with a liquid inlet port and a liquid outlet port, wherein the liquid inlet port is located at a bottom of the heat exchanger and the liquid outlet port is located at a top of the heat exchanger;
where the liquid inlet port is connected to the liquid cooling source through a liquid inlet branch pipe, and the liquid outlet port is connected with outside through a liquid outlet branch pipe.

In a possible implementation, the top of the heat exchanger is provided with an exhaust valve; the liquid inlet branch pipe is provided with a control component, which is used to control on-off of the liquid inlet branch pipe.

For a containerized data center provided in the present application, the containerized data center includes a data container and a heat dissipation module, where the heat dissipation module is installed on an outer wall of the container body of the data container, and the heat dissipation module is provided corresponding to the vent provided on a side wall of the container body. Where, the heat dissipation module includes a housing, a fan and a heat exchanger. The housing is sealed and connected to the outer wall of the container body, and is communicated with the vent, the fan and the heat exchanger are provided in the housing, the heat dissipation module guides the air in the container body to the heat exchanger by using the fan, then exchanges heat with the air in the container body through the heat exchanger to dissipate heat from the data container. The heat dissipation module adopts modular design with low power, and the containerized data center has a simple structure, easy assembly, high heat dissipation efficiency, good heat dissipation effect, low energy consumption and pollution-free nature.

### BRIEF DESCRIPTION OF DRAWINGS

In order to more clearly illustrate technical solutions in embodiments of the present application or in the prior art, a brief introduction of drawings required to be used in the description of the embodiments or the prior art is provided below. It is obvious that the drawings described below are some embodiments of the present application. For ordinary person skilled in the art, other drawings can also be obtained according to these drawings without creative labor.
FIG. 1 is a schematic structural diagram of a containerized data center provided in an embodiment of the present application.
FIG. 2 is a schematic structural diagram of the containerized data center in FIG. 1 from another perspective.
FIG. 3 is a schematic structural diagram of a heat dissipation module provided in an embodiment of the present application from a perspective.
FIG. 4 is a schematic structural diagram of a heat dissipation module provided in an embodiment of the present application from another perspective.
FIG. 5 is a partial exploded structural diagram of a containerized data center provided in an embodiment of the present application.
FIG. 6 is a partial perspective diagram of a containerized data center provided in an embodiment of the present application.
FIG. 7 is a perspective diagram of a heat dissipation module provided in an embodiment of the present application.

Reference signs:
100-data container;
110-container body; 120-vent;
121-air outlet portion; 122-air inlet portion;
200-heat dissipation module;
210-housing; 220-fan; 230-heat exchanger; 240-first flow guide portion;
201-air inlet chamber; 211-front wall portion; 212-rear wall portion; 231-heat exchange tube; 232-heat dissipation fin; 233-liquid inlet vertical pipe; 234-liquid outlet vertical pipe;
2121-second flow guide portion; 2301-liquid inlet port; 2302-liquid outlet port; 2303-exhaust valve.

### □DESCRIPTION OF EMBODIMENTS

When data containers work in harsh environment areas such as high salt and alkali, high humidity and heat, and acid fog, equipment inside the container is vulnerable to affected by the external environment, which affects its working stability and lifetime. At this time, sealed containers are mostly selected to prevent external air from entering.

When sealed containers are selected, the heat generated by kinds of electrical equipment in the containers cannot be effectively dissipated, resulting in excessively high operating temperature of equipment in the containers, which will affect operating performance of the equipment, and even cause equipment failure.

To ensure stable operation of the equipment in sealed containers, at present, it is common to use air conditioners which are resistant to salt and alkali corrosion to dissipate heat from the equipment inside the container. However, the high power consumption of air conditioners results in high costs for heat dissipation, and the use of refrigerants (such as Freon) will cause air pollution.

In view of this, an embodiment of the present application provides a containerized data center, the containerized data center includes a data container and a heat dissipation module, where the heat dissipation module is installed on an outer wall of a container body of the data container, and the heat dissipation module is provided corresponding to the vent provided on a side wall of the container body. Where, the heat dissipation module includes a housing, a fan and a heat exchanger. The housing is sealed and connected to the outer wall of the container body, and is communicated with the vent, the fan and the heat exchanger are provided in the housing, the heat dissipation module guides the air in the container body to the heat exchanger by using the fan, then exchanges heat with the air in the container body through the heat exchanger to dissipate heat from the data container. The heat dissipation module adopts modular design with low power, and the containerized data center has a simple structure, easy assembly, high heat dissipation efficiency, good heat dissipation effect, low energy consumption and pollution-free nature.

To make the objectives, technical solutions, and advantages of the present application clearer, the following will provide a clear and complete description of the technical solutions in the embodiments of the present application with reference to the drawings in embodiments of the present application. It should be obvious that the described embodiments are only a part of the embodiments of the present application, not all of embodiments. Based on the embodiments of the present application, all other embodiments obtained by those of ordinary skill in the art without creative labor are within the protection scope of the present application.

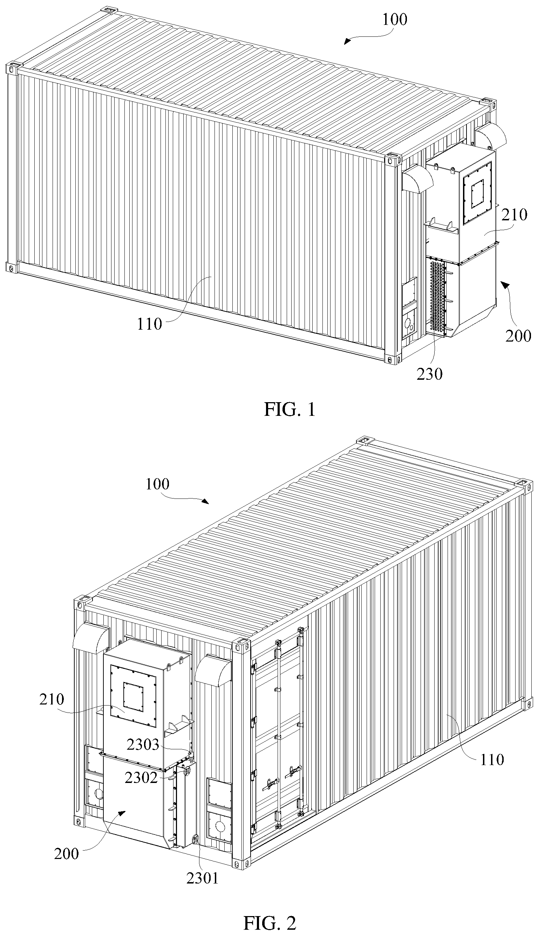

FIG. 1 is a schematic structural diagram of a containerized data center provided in an embodiment of the present application; FIG. 2 is a schematic structural diagram of the containerized data center in FIG. 1 from another perspective.

As shown in FIG. 1 or FIG. 2, an embodiment of the present application provides a containerized data center, the containerized data center includes a data container 100 and a heat dissipation module 200. The data container 100 includes a container body 110, the container body 110 is provided with equipment (or apparatuses) such as servers, power distribution cabinets, control cabinets, and water pumps, which are not shown in the figures. The heat dissipation module 200 is installed on an outer wall of the container body 110 and is used to dissipate heat from equipment in the container body 110.

The containerized data center in the present embodiment adopts a sealed design, in other words, a whole structure consisting of the data container 100 and the heat dissipation module 200 is sealed. With such arrangement, inner walls of the containerized data center can be isolated from the external environment, which can prevent external air from entering the container body 110 of the data container 100, especially when the containerized data center works in harsh environment areas such as high salt and alkali, high humidity and heat, and acid fog, it can prevent the external air from affecting the lifetime of the equipment in the container body 110 to ensure the stability and reliability of the equipment.

It should be noted that a liquid cooling system is usually arranged in the container body 110 to cool the servers to ensure stable operation of the servers. Exemplarily, there are usually multiple servers arranged within the container body 110, the servers form a server group in rows (or columns). According to the architecture form of the server group, the corresponding liquid cooling system can be arranged to cool each server through a circulation of coolant in the liquid cooling system, so that working temperature of each server is maintained within an appropriate range.

The liquid cooling system of the server may include multiple cold plates, each cold plate corresponds to each server group (or each server), and each cold plate is connected with a liquid inlet branch pipe and a liquid outlet branch pipe. The data container 100 is equipped with a liquid cooling source, which is connected to the container body 110 of the data container 100 through a main liquid inlet pipe, and the coolant in the main liquid inlet pipe is transported to each cold plate through each liquid inlet branch pipe. After the coolant flows in each cold plate and takes away the heat of the server, the coolant with increased temperature flows to the main liquid outlet pipe through each liquid outlet branch pipe, and finally discharges from the main liquid outlet pipe. Such circulation may cool each server in the container body 110.

The liquid cooling system is usually used only to cool the server and does not work on other equipment in the container body 110. Other equipment in the container body 110, such as power distribution cabinets, control cabinets, circulation pumps, etc., will also generate heat during working process, and the heat generated by this equipment will usually directly dissipated into the air in the container body 110. For example, the fans are usually arranged inside the power distribution cabinets, control cabinets and other equipment, and this equipment quickly dissipate heat into the container body 110 through the fans, while other equipment slowly dissipate heat into the container body 110.

In addition, part of the heat in the container body 110 also comes from external radiation heat, for example, sunlight and the heat radiated into the container body 110 by other external equipment. Where the container body 110 is usually made of high-strength alloy materials (such as alloy steel), and radiation absorption rate of the container body 110 itself is high, which will also increase the heat in the container body 110.

When the data container 100 adopts a sealed design, the heat dissipated into the container body 110 by the equipment and the external radiation heat cannot be effectively discharged, which will cause the temperature in the container body 110 continues to increase. Then, the equipment in the container body 110 works in a high temperature environment, which will affect the operating performance of the equipment and reduce service life of the equipment.

In this case, in the present embodiment, the heat dissipation module 200 is installed outside the data container 100, and the heat dissipation module 200 is sealed and connected to the outer wall of the container body 110. On the one hand, the heat in the container body 110 can be taken away through the heat dissipation module 200 to dissipate heat from the equipment in the container body 110 to ensure the operating performance and service life of the equipment in the container body 110. On the other hand, the heat dissipation module 200 is sealed and connected with the data container 100, and the overall data center is a sealed structure, which can prevent the internal equipment of the data container 100 from being affected by the external environment and ensure the working stability and reliability of the internal equipment.

In addition, in the present embodiment, the heat dissipation module 200 adopts a modular design, and the heat dissipation module 200 itself forms an overall structure, which is easy to install on the outer wall of the data container 100, and easy to disassemble from the data container 100. In this way, the overall structure of the containerized data center is simple, easy to assemble and disassemble, which can save installation time and reduce installation costs.

Moreover, it is understood that the heat dissipation module 200 is a modular structure, which has higher flexibility and fewer installation restrictions. Therefore, an installation position of the heat dissipation module 200 may be designed according to actual requirements, and the heat dissipation module 200 can be provided corresponding to a high heat generation area of the data container 100. In other words, the heat dissipation module 200 can be installed on the outer wall where the high heat generation area of the data container 100 is located.

For example, if a power distribution cabinet is located in the high heat generation area of the data container 100, the heat dissipation module 200 can be provided on the outer wall of the container body 110 closest to the power distribution cabinet. Of course, the position of the heat dissipation module 200 can be designed according to a layout structure of the data container 100, with the aim of enabling the heat dissipation module 200 to quickly and comprehensively take away the heat in the container body 110.

Based on heat dissipation requirements of the data container 100, only one heat dissipation module 200 may be installed on the outer wall of the data container 110, the heat dissipation module 200 may be provided corresponding to an area with the highest heat dissipation of the data container 100. Alternatively, two or more heat dissipation modules 200 may be installed on the outer wall of the data container 110, where different heat dissipation modules 200 are provided corresponding to different high heat generation areas of the data container 100.

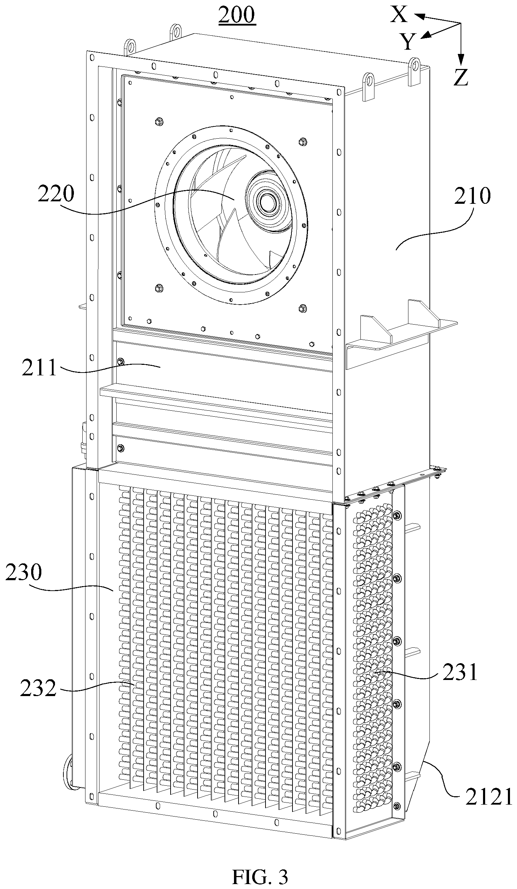

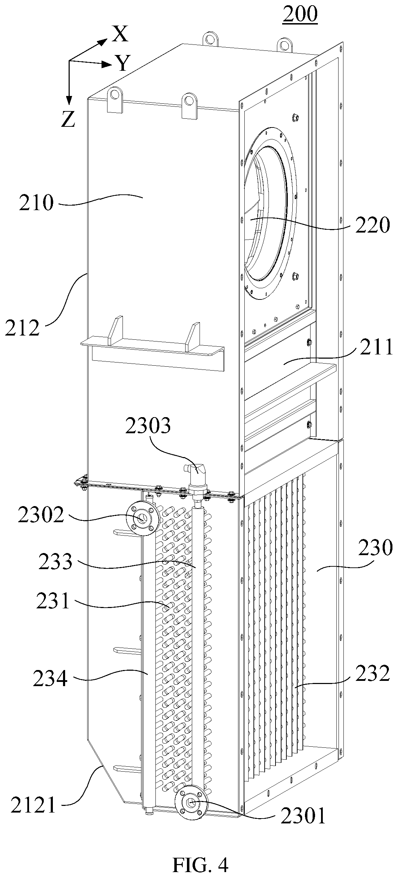

FIG. 3 is a schematic structural diagram of a heat dissipation module provided in an embodiment of the present application from a perspective; FIG. 4 is a schematic structural diagram of the heat dissipation module provided in an embodiment of the present application from another perspective.

As shown in FIG. 3 or FIG. 4, a heat dissipation module 200 includes a housing 210, a fan 220 and a heat exchanger 230, where the housing 210 is sealed and connected to an outer wall of the container body 110 of the date container 100 (See FIG. 1 or FIG. 2), and the fan 220 and the heat exchanger 230 are provided in the housing 210. The air in the container body 110 of the data container 100 is guided by the fan 220 into the housing 210 of the heat dissipation module 200 and flows to the heat exchanger 230, then the coolant flows through the heat exchanger 230, and the coolant exchanges heat with the air to reduce the temperature of the air, then the cooled air flows back to the housing 110 of the data container 100.

With such circulation, the heat in the container body 110 of the data container 100 is taken away by the heat dissipation module 200, to dissipate the heat from equipment in the container body 110 and maintain the interior of the container body 110 within an appropriate temperature range, in other words, to maintain the equipment in the container body 110 works within an appropriate temperature range, ensuring the operating performance of the equipment and extending the service life of the equipment.

The heat exchanger 230 can be connected with the above-mentioned liquid cooling source, which provides the coolant to the heat exchanger 230, the coolant flows in the heat exchanger 230 and performs heat exchange with the air entering the heat dissipation module 200 to cool the air in the container body 110. At the same time, the temperature of the coolant in the heat exchanger 230 increases, and the coolant is discharged to the external environment after the temperature increases. The liquid cooling source continuously delivers the coolant to the heat exchanger 230 to meet requirements of the heat exchanger 230 to cool the air in the container body 110.

As shown in FIG. 4, a liquid inlet port 2301 and a liquid outlet port 2302 may be provided on the heat exchanger 230, where the liquid inlet port 2301 is connected with the liquid cooling source, and the liquid outlet port 2302 is connected with the external environment. The coolant provided by the liquid cooling source enters the heat exchanger 230 from the liquid inlet port 2301, flows in the heat exchanger 230 to preform heat exchange, and after that the coolant is discharged from the liquid outlet port 2302 of the heat exchanger 230 to the external environment.

Exemplarily, the liquid inlet port 2301 on the heat exchanger 230 can be connected to the above main liquid inlet pipe through a liquid inlet branch pipe (not shown in the figure), and the liquid outlet port 2302 on the heat exchanger 230 can be connected to the above main liquid inlet pipe through a liquid inlet branch pipe (not shown in the figure).

The coolant provided by the liquid cooling source is delivered through the main liquid inlet pipe to the liquid cooling system of the server and (through the liquid inlet branch pipe) to the heat exchanger 230. The coolant in the liquid cooling system of the server is discharged to the main liquid outlet pipe after flowing through the heat exchange, and, the coolant in the heat exchanger 230 is discharged to the main liquid outlet pipe through the liquid outlet branch pipe after flowing through the heat exchange and finally discharged to the external environment through the main liquid outlet pipe.

The liquid inlet branch pipe can be provided with a control component, such as a water inlet valve or a plug, which is used to control the on-off of the liquid inlet branch pipe. When the heat dissipation module 200 is required to dissipate heat in the data container 100, the control component controls the liquid inlet branch pipe to communicate with the main liquid inlet pipe so that the coolant can flow through the heat exchanger 230. When the heat dissipation module 200 is not required, the control component controls the liquid inlet branch pipe to disconnect from the main liquid inlet pipe to stop providing coolant to the heat exchanger 230, and to discharge the coolant in the heat exchanger 230.

After the heat exchange between the coolant and the air in the container body 110, the temperature of the coolant will increases, and the coolant with increased temperature will be easy to gather above the heat exchanger 230, and the fluidity will be reduced. In this regard, as further shown in FIG. 4, in the embodiment, the liquid inlet port 2301 on the heat exchanger 230 is provided at the bottom of the heat exchanger 230, and the liquid outlet port 2302 on the heat exchanger 230 is provided at the top of the heat exchanger 230, that is, the coolant enters the heat exchanger 230 from the bottom of the heat exchanger 230 and discharges the heat exchanger 230 from the top of the heat exchanger 230.

With such arrangement, after the coolant entering the heat exchanger 230 from the bottom of the heat exchanger 230 is exchanged heat with the air, the temperature of the coolant increases and the coolant flows to the top of the heat exchanger 230. It can continuously allow the coolant to enter the heat exchanger 230, and the coolant after performing the heat exchange continuously flows upward. Furthermore, the coolant can be fully flowed in the heat exchanger 230, and the flow rate of the coolant in the heat exchanger 230 is high to fully perform heat exchange with the air in the heat dissipation module 200 to ensure cooling effect of the heat dissipation module 200 on the data container 100. In addition, the coolant in the heat exchanger 230 continues to flow upward, which helps to discharge the air in the heat exchanger 230, so that the coolant will be filled with the heat exchanger 230, and the temperature in the heat exchanger 230 is more uniform, which is conducive to improving cooling effect of the heat exchanger 230.

As shown in FIG. 3 or FIG. 4, as an implementation, the heat exchanger 230 may adopt a tube-fin structure, in other words, the heat exchanger 230 may be a tube-fin heat exchanger. The heat exchanger 230 may include a plurality of heat exchange tubes 231 and a plurality of heat dissipation fins 232, where each heat exchange tube 231 may be arranged at intervals, the heat dissipation fins 232 are connected to the periphery of each heat exchange tube 231, and each the heat dissipation fin 232 is arranged at intervals, in other words, each heat exchange tube 231 passes through each heat dissipation fin 232 arranged at intervals.

Exemplarily, the heat exchange tube 231 may be serpentine in structure, for example, the heat exchange tube 231 extends serpentinely along a plane direction of the heat exchanger 230 (XY directions shown in FIG. 3 or FIG. 4), and there are a plurality of heat exchange tubes 231 arranged at intervals along a height direction of the heat exchanger 230 (the Z direction shown in FIG. 3 or FIG. 4). The heat dissipation fin 232 can be extended along the height direction of the heat exchanger 230, and the heat dissipation fin 232 can be along the plane direction of the heat exchanger 230, as shown in FIG. 3 or FIG. 4, the heat dissipation fins 232 can be extended along YZ directions, and each heat dissipation fin 232 is arranged at intervals along the X direction.

The heat exchange tube 231 is used for coolant to flow through, and the coolant exchanges heat with the air flowing around the heat exchange tube 231 to cool the air. The heat dissipation fin 232 is used to increase the cross-sectional area of the heat exchanger 230 to separate space around each heat exchange tube 231 into multiple convection channels. In this way, the heat dissipation fin 232 forms a blocking effect on the flow of the air, which can reduce air velocity in the convection channel and increase air pressure in the convection channel to make the air pass through each convection channel of the heat exchanger 230 smoothly. Thus, the air is fully heat exchanged with the coolant in the heat exchange tube 231 to improve the cooling effect of the heat exchanger 230.

In addition, the heat dissipation fin 232 increases the heat exchange area of the heat exchanger 230, and the air can exchange heat with the heat dissipation fin 232, transfer heat to the heat dissipation fin 232, and the heat dissipation fin 232 will conduct heat to the tube wall of the heat exchange tube 231, and the tube wall of the heat exchange tube 231 will exchange heat into the coolant. Thus, the heat exchange efficiency of the heat exchanger 230 can be improved and the heat exchange effect of heat exchanger 230 can be enhanced.

In addition, as shown in FIG. 4, a liquid inlet vertical pipe 233 and a liquid outlet vertical pipe 234 can be provided on the heat exchanger 230, and both the liquid inlet vertical pipe 233 and the liquid outlet vertical pipe 234 extend in the height direction of the heat exchanger 230 (the Z direction in FIG. 4), for example, the liquid inlet vertical pipe 233 and the liquid outlet vertical pipe 234 extend to both ends of the heat exchanger 230. Where, the liquid inlet port 2301 on the heat exchanger 230 can be provided at a bottom end of the liquid inlet vertical pipe 233, and the liquid outlet port 2302 on the heat exchanger 230 can be provided at a top end of the liquid outlet vertical pipe 234.

The liquid inlet vertical pipe 233 and the liquid outlet vertical pipe 234 may be adjacent to both sides of the heat exchanger 230 respectively, and for each heat exchange tube 231 arranged at intervals along the height direction of the heat exchanger 230, the liquid inlet vertical pipe 233 is communicated with one end of each heat exchange tube 231, and the liquid outlet vertical pipe 234 is communicated with the other end of each heat exchange tube 231. With such arrangement, it can accelerate the flow rate of the coolant in the heat exchanger 230, increase the pressure of the coolant in the heat exchanger 230, and then improve the heat exchange efficiency of the heat exchanger 230 and enhance the heat exchange effect of the heat exchanger 230.

As further shown in FIG. 4, in the present embodiment, the top of the heat exchanger 230 is also provided with an exhaust valve 2303, which is used to discharge the air in the heat exchanger 230, so as to fill the coolant with the heat exchanger 230, make the temperature inside heat exchanger 230 more uniform, and improve the cooling effect of heat exchanger 230. For example, the exhaust valve 2303 may be arranged on the top of the liquid inlet vertical pipe 233.

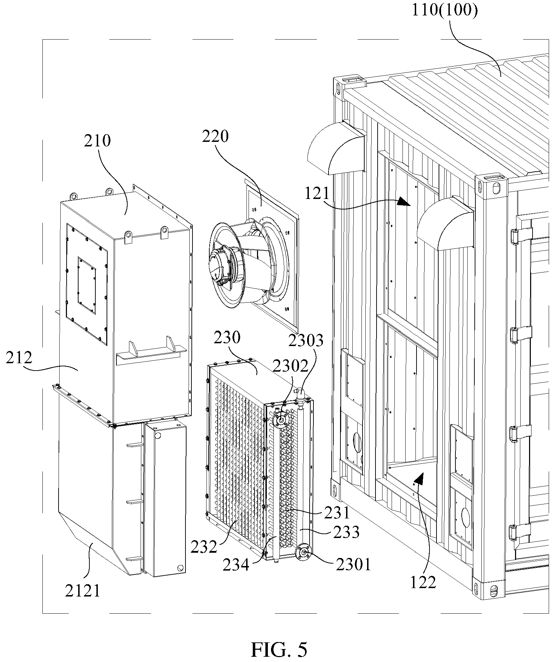

FIG. 5 is a partial exploded structural diagram of a containerized data center provided in an embodiment of the present application. As shown in FIG. 5, in order to realize a circulation of air between the data container 100 and the heat dissipation module 200, a vent 120 can be provided on the side wall of the container body 110 of the data container 100, and the heat dissipation module 200 is provided corresponding to the vent 120, or the vent 120 is located in the range covered by the housing 210 of the heat dissipation module 200. The air in the container body 110 enters the heat dissipation module 200 through the vent 120. After being cooled in the heat dissipation module 200, the air flows back into the container body 110 through the vent 120.

On a side of the housing 210 of the heat dissipation module 200 facing the side wall of the container body 110, the part corresponding to the vent 120 of the container body 110 can be open so that the vent 120 of the container body 110 is in communication with the housing 210 of the heat dissipation module 200. In this way, the air in the container body 110 can pass through the vent 120 into the heat dissipation module 200 to exchange heat with the heat exchanger 230, and the cooled air can also pass through the vent 120 and flow back to the data container 100.

The vent 120 provided on the side wall of the container body 110 of the data container 100 may include an air outlet portion 121 and an air inlet portion 122, where the air outlet portion 121 is separated from the air inlet portion 122. The fan 220 is provided corresponding to the air outlet portion 121, and the heat exchanger 230 is provided corresponding to the air inlet portion 122. Under suction effect of the fan 220, the air in the container body 110 is passed out from the air outlet portion 121 on the side wall of the container body 110, into the housing 210 of the heat dissipation module 200, and is guided from the fan 220 to the heat exchanger 230, then, after heat exchange with the heat exchanger 230, the cooled air is flowed back to the container body 110 through the air inlet portion 122 on the side wall of the container body 110.

By setting the air outlet portion 121 and the air inlet portion 122 respectively, the air outlet portion 121 allows the air inside the container body 110 to pass out, and the air inlet portion 122 allows the air from the heat dissipation module 200 to pass into the container body 110. With such arrangement, the air may circulate more smoothly between the data container 100 and the heat dissipation module 200 to reduce resistance of air flow between the data container 100 and the heat dissipation module 200 and improve the heat dissipation efficiency of the containerized data center.

As for a connection between the housing 210 of the heat dissipation module 200 and the container body 110 of data container 100, the housing 210 of the heat dissipation module 200 and the container body 110 of data container 100 can be connected by bolts, screws and other locking parts. In this way, the heat dissipation module 200 can be securely connected to the data container 100, and the heat dissipation module 200 can be easily installed and disassembled from the data container 100.

In addition, a sealing layer (not shown in the figure) is provided between the housing 210 of the heat dissipation module 200 and the outer wall 110 of the container body 110 the data container 100 to realize a sealed connection between the heat dissipation module 200 and the data container 100 through the sealing layer. For example, the edge of the housing 210 of the heat dissipation module 200 is provided with a flange, the housing 210 is fitted on the outer wall of the container body 110 with the flange, and the sealing layer is fitted between the flange of the housing 210 and the outer wall of the container body 110.

Exemplarily, the sealing layer may include a silicone layer or a rubber layer, and the sealing layer is squeezed by locking force between the housing 210 of the heat dissipation module 200 and the container body 110 of the data container 100, so that the sealing layer is tightly fitted between the housing 210 of the heat dissipation module 200 and the outer wall of the container body 110. Alternatively, the sealing layer may be a sealant, which can be coated on the flange of the housing 210 and a gap between the housing 210 and the outer wall of the container body 110 is sealed through the sealant. Alternatively, on the basis of the sealing layer including the silicone layer (or the rubber layer), a sealant is provided on one or both sides of the silicone layer (or the rubber layer), where the sealant and the silicone layer (or the rubber layer) together form a sealing layer.

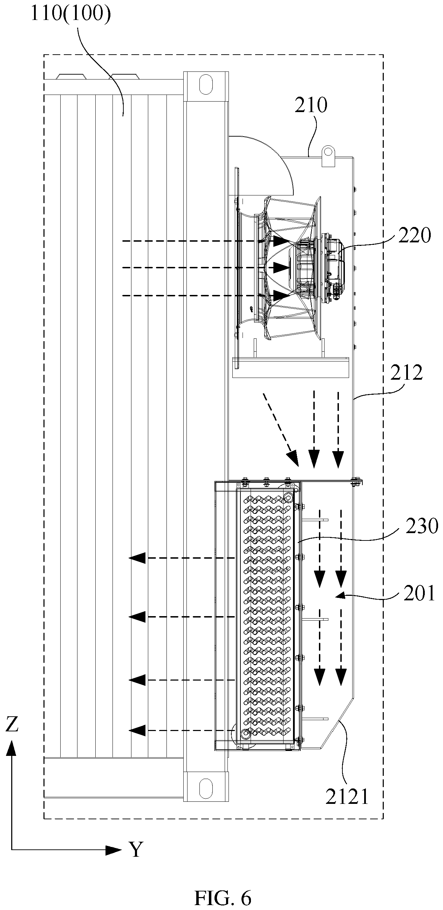

FIG. 6 is a partial perspective diagram of a containerized data center provided in an embodiment of the present application. As shown in FIG. 6, for a layout structure of the heat dissipation module 200, in the present embodiment, the fan 220 can be located above the heat exchanger 230 in the housing 210 of the heat dissipation module 200. In other words, the whole heat dissipation module 200 can be extended along the height direction of the data container 100 (the Z direction in FIG. 6), with the fan 220 above and the heat exchanger 230 below.

After the air in the container body 110 of the data container 100 is heated, its density and fluidity are reduced, and hot air is usually concentrated in an upper part of the container body 110. By placing the fan 220 on the above, and providing an air outlet portion 121 on the side wall of the container body 110 on the upper part of the container body 110, it is beneficial for the fan 220 to quickly suck the hot air in the container body 110 into the housing 210 of the heat dissipation module 200. By placing the heat exchanger 230 below, and providing an air inlet portion 122 on the side wall of the container body 110 corresponds to the lower part of the container body 110, the air cooled by the heat exchanger 230 enters the lower part of the container body 110.

As indicated by dashed arrows in FIG. 6, equipment in the container body 110 dissipates heat to the external environment, which increases the air temperature in the container body 110. The hot air is concentrated in the upper part of the container body 110, passes through the air outlet portion 121 on the upper side of the side wall of the container body 110 and is sucked into the housing 210 of the heat dissipation module 200 by the fan 220 located above. The fan 220 guides the hot air to the heat exchanger 230 located below, the heat exchanger 230 cools the hot air into cold air, and the cold air is flowed back to the lower part of the container body 110 from the air inlet portion 122 on the lower side of the side wall of the container body 110. With such circulation, it is used to dissipate heat from the equipment in the container body 110.

In the present embodiment, the hot air in the container body 110 is discharged from the upper part of the container body 110, and the heat dissipation module 200 cools the hot air into cold air and enters the lower part of the container body 110. In this way, it is conducive to the hot air in the container body 110 smoothly and quickly entry of the heat dissipation module 200, and the cold air is flowed back to the lower part of the container body 110, the fluidity of the cold air is high, which can accelerate the flow rate of the air in the container body 110, improve the heat dissipation efficiency of the data container 100, and improve the heat dissipation effect of the data container 100.

As further shown in FIG. 6, in order to enable the fan 220 to draw the air in the container body 110 into the housing 210 and make the air in the housing 210 flow to the heat exchanger 230 below the housing 210, a centrifugal fan may be selected as a fan 220, and an axial direction of the fan 220 may be perpendicular to the side wall of the container body 110. In this way, the air in the container body 110 can vertically pass through the air outlet portion 121 on the side wall of the container body 110 to enter the housing 210 in a direction parallel to the axial direction of the fan 220. In addition, high-speed rotating impellers of the fan 220 accelerate the air and change a flow direction, so that the air in the housing 210 quickly flows to the heat exchanger 230 below the fan 220.

For ease of explanation, in the present embodiment, a side wall of the housing 210 of the heat dissipation module 200 facing a side of the container body 110 of the data container 100 is defined as a front wall portion 211 of the housing 210, and a side wall of the housing 210 of the heat dissipation module 200 away from a side of the container body 110 of the data container 100 is defined as a rear wall portion 212 of the housing 210. In addition, a side of the heat exchanger 230 facing the container body 110 of the data container 100 is defined as a front side of the heat exchanger 230, and a side of the heat exchanger 230 away from the container body 110 of the data container 100 is defined as a rear side of the heat exchanger 230.

As mentioned above, in the side of the housing 210 facing the container body 110, and the area of the vent 120 on the container body 110 may be open. For example, in the side of the housing 210 facing the container body 110, both the parts corresponding to the fan 220 and the heat exchanger 230 are open, and the part between the fan 220 and the heat exchanger 230 is the front wall portion 211 of the housing 210 (see FIG. 3 or FIG. 4).

As further shown in FIG. 6, there may be a gap between the rear side of the heat exchanger 230 and the rear wall portion 212 of the housing 210, and the gap forms an air inlet channel, in other words, the rear side of the heat exchanger 230 and the housing 210 are enclosed together to form an air inlet chamber 201. The fan 220 sucks the air in the container body 110 into the housing 210, and makes the air flow to the lower part of the housing 210, so that the air enters the air inlet chamber 201 at the rear side of the heat exchanger 230. The air in the air inlet chamber 201 flows from the rear side of the heat exchanger 230 to the front side of the heat exchanger 230 to cool the air through the heat exchanger 230, and the cooled air is flowed back from the front side of the heat exchanger 230 through the air inlet portion 122 on the side wall of the container body 110 to the container body 110.

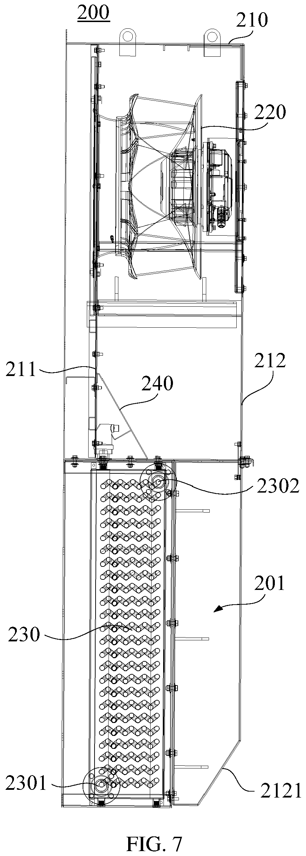

FIG. 7 is a perspective diagram of a heat dissipation module provided in an embodiment of the present application. As shown in FIG. 7, in some implementations, a first flow guide portion 240 may be provided in the housing 210 of the heat dissipation module 200, the first flow guide portion 240 is located between the fan 220 and the heat exchanger 230. In addition, the upper end of the first guide portion 240 may be connected to the front wall portion 211 of the housing 210, and the lower end of the first guide portion 240 may be inclined towards the air inlet chamber 201.

As shown combined with FIG. 6 and FIG. 7, after acceleration and direction change of the fan 220, the air quickly flows to the heat exchanger 230 under the fan 220. The first flow guide portion 240 provided inclined guides the flow direction of the air and gathers the air towards the inlet chamber 201 at the rear side of the heat exchanger 230. It will avoid the top of the heat exchanger 230 to obstruct airflow, and avoid vortex formation above the heat exchanger 230 to allow air to flow smoothly into the air inlet chamber 201. In addition, the heat dissipation efficiency and heat dissipation effect of the heat dissipation module 200 are improved.

In addition, by providing the first flow guide portion 240 between the fan 220 and the heat exchanger 230, the cross-sectional area of the air flow channel between the fan 220 and the heat exchanger 230 is gradually decreases in the direction of air flow, which is conducive to increasing the air pressure and reducing the air velocity, so that the air and the heat exchanger 230 can fully exchange heat, the cooling efficiency of the heat exchanger 230 will be improved and the cooling effect of the heat dissipation module 200 will be enhanced.

In addition, as shown in FIG. 6 or FIG. 7, the rear wall portion 212 of the housing 210 of the heat dissipation module 200 also has a second flow guide portion 2121, which is located at the bottom end of the rear wall portion 212. In addition, from the upper end of the second flow guide portion 2121 to the lower end of the second flow guide portion 2121, the second flow guide portion 2121 is inclined towards the container body 110 of the data container 100.

The second flow guide portion 2121 at the bottom end of the rear wall portion 212 of the housing 210 also has a guiding effect, which can guide the air to flow from the air inlet chamber 201 to the front side of the heat exchanger 230, so that the air passes through the heat exchanger 230 and performs heat exchange with the heat exchanger 230, which contributes to enabling the cooled air to smoothly flow back to the container body 110. In addition, the second flow guide portion 2121 gradually reduces the cross-sectional area at the bottom end of the air inlet chamber 201, which can increase the air pressure in the air inlet chamber 201 and reduce the air velocity, so that the air can fully exchange heat with the heat exchanger 230, so as to improve the air cooling efficiency of the heat exchanger 230 and enhance the heat dissipation effect of the heat dissipation module 200.

In the description of the present application, it should be understood that the orientation or position relationships indicated by the terms "center", "longitudinal", "transverse", "length", "width", "thickness", "up", "down", "front", "rear", "left", "right", "vertical", "horizontal", "top", "bottom", "inner" and "outer" etc., are based on the orientation or position relationships shown in the accompanying drawings, they are only for facilitating the description of the present application and simplifying the description, and do not indicate or imply that the device or element referred to must have a particular orientation, be constructed and operated in a particular orientation. Therefore, they cannot be understood as a limitation of the present application.

Finally, it should be noted that the aforementioned embodiments are intended to illustrate the technical solutions of the present application, but not to intended to limit them; notwithstanding the detailed description of the present application by reference to the foregoing embodiments, it should be understood to those skilled in the art that they can still modify the technical solutions described in the foregoing embodiments and equivalently replace some or all of the technical features thereof; such modifications or replacements will not cause the essence of the corresponding technical solutions to depart from the scope of the technical solutions of the embodiments of the present application.

## Claims

1. A containerized data center, comprising:
a data container, comprising a container body, and a side wall of the container body is provided with a vent;
a heat dissipation module, installed on an outer wall of the container body, and provided corresponding to the vent;
wherein the heat dissipation module comprises a housing, a fan and a heat exchanger; the housing is sealed and connected to the outer wall of the container body, and is communicated with the vent; both the fan and the heat exchanger are provided in the housing, the fan guides air in the container body to the heat exchanger, and the heat exchanger is connected with a liquid cooling source.

2. The containerized data center according to claim 1, wherein the fan is located above the heat exchanger.

3. The containerized data center according to claim 2, wherein the vent comprises an air outlet portion and an air inlet portion;
wherein the air outlet portion is provided above the air inlet portion, the fan is provided corresponding to the air outlet portion, and the heat exchanger is provided corresponding to the air inlet portion.

4. The containerized data center according to any one of claims 1-3, wherein there is a gap between the heat exchanger and a rear wall portion of the housing, the heat exchanger and the housing are enclosed together to form an air inlet chamber;
wherein the rear wall portion is a side wall of the housing away from the container body.

5. The containerized data center according to claim 4, wherein a first flow guide portion is provided in the housing, the first flow guide portion is located between the fan and the heat exchanger;
wherein an upper end of the first flow guide portion is connected to a front wall portion of the housing, and a lower end of the first flow guide portion is inclined towards the air inlet chamber; the front wall portion is a side wall of the housing facing the container body.

6. The containerized data center according to claim 4, wherein the rear wall portion of the housing has a second flow guide portion, the second flow guide portion is located at a bottom end of the rear wall portion;
and, the second flow guide is inclined towards the housing from an upper end of the second flow guide portion to a lower end of the second flow guide portion.

7. The containerized data center according to any one of claims 1-3, wherein a sealing layer is provided between the housing and the outer wall of the housing.

8. The containerized data center according to any one of claims 1-3, wherein the heat dissipation module is provided corresponding to a high heat generation area of the data container.

9. The containerized data center according to any one of claims 1-3, wherein the heat exchanger is provided with a liquid inlet port and a liquid outlet port, wherein the liquid inlet port is located at a bottom of the heat exchanger and the liquid outlet port is located at a top of the heat exchanger;
wherein the liquid inlet port is connected to the liquid cooling source through a liquid inlet branch pipe, the liquid outlet port is connected with outside through a liquid outlet branch pipe.

10. The containerized data center according to claim 9, wherein the top of the heat exchanger is provided with an exhaust valve; the liquid inlet branch pipe is provided with a control component, which is used to control on-off of the liquid inlet branch pipe.
